## Europäisches Patentamt

(19) **European Patent Office**

**Office européen des brevets**

(11) Veröffentlichungsnummer: **0 097 611**

**A2**

(12) **EUROPÄISCHE PATENTANMELDUNG**

(21) Anmeldenummer: **83710033.8**

(22) Anmeldetag: **10.06.83**

(51) Int. Cl.³: **H 01 L 31/02**
**H 01 L 33/00, G 02 B 7/26**

(30) Priorität: **21.06.82 SE 8203826**

(43) Veröffentlichungstag der Anmeldung:
**04.01.84 Patentblatt 84/1**

(84) Benannte Vertragsstaaten:
**CH DE FR GB LI**

(71) Anmelder: **ASEA AB**

**S-721 83 Västeras(SE)**

(72) Erfinder: **Dubon, Chantal, Dipl.-Ing.**
**51 Av. de Paris**
**FR-78000 Versailles(FR)**

(72) Erfinder: **Hök, Bertil, Dr. phil.**
**Sportfiskargatan 53**
**S-723 48 Västeras(SE)**

(72) Erfinder: **Ovrén, Christer, Dr.-Ing.**
**Vilddjursvägen 9**
**S-722 43 Västeras(SE)**

(74) Vertreter: **Boecker, Joachim, Dr.-Ing.**
**Rathenauplatz 2-8**
**D-6000 Frankfurt a.M. 1(DE)**

(54) **Hermetisch dichte Verbindung zwischen einem Galliumarsenidbauteil und einem Glaskörper.**

(57) Hermetisch dichte Verbindung (Versiegelung) zwischen einem Galliumarsenidbauteil (1) und einem Glaskörper (3) mit zwei miteinander in Kontakt stehenden Flächen (4), die keine Unebenheiten im Bereich von 0,1 μm und 100 μm haben. Gemäß der Erfindung ist die Kontaktfläche zwischen beiden Teilen von organischen und/oder anorganischen Bindemitteln gereinigt und enthält keine optische erfaßbaren Farbveränderungen.

FIG. 1a

Patentanwalt und Rechtsanwalt
Dr.-Ing. Dipl.-Ing. Joachim B o e c k e r

6 Frankfurt / Main 1 , 0097611
Rathenauplatz 2 - 8        B/d 21 282 PE
Telefon: (06 11) *28 23 55
Telex: 4 189 066 itax d

A S E A    Aktiebolag
Västeras/Schweden

Hermetisch dichte Verbindung zwischen einem
Galliumarsenidbauteil und einem Glaskörper

Die Erfindung betrifft eine hermetisch dichte Verbindung (Versiegelung) zwischen einem Galliumarsenidbauteil und einem Glaskörper gemäß dem Oberbegriff des Anspruches 1.

Bei der schnellen Entwicklung der Halbleiterelektronik findet Galliumarsenid steigendes Interesse, und zwar vor allem aufgrund seiner folgenden Eigenschaften:

Sein direkter Bandabstand ermöglicht eine effektive elektrooptische Energieumwandlung, was in Fotodioden, Leuchtdioden, Laserdioden und optischen Sensoren ausgenutzt wird.
Seine hohe Mobilität kann in der Bandbreite bei analoger und digitaler Elektronik ausgenutzt werden.
Seine gute Legierbarkeit, z.B. zu $Al_xGa_{1-x}As$, ermöglicht es, Materialparameter, wie Bandabstand und Ätzbarkeit, den verschiedenen Prozessen genau anzupassen.

Bei der Herstellung von optischen Bauteilen aus GaAs, insbesondere für opto-elektrische Anordnungen, wird normalerweise eine konventionelle Kapselungstechnik angewendet, nämlich der Einschluß des GaAs-Bauteils in eine Metallkapsel, die ein Glasfenster für den optischen Anschluß hat. In einigen Fällen wird die Kapsel außerdem mit Linsenelementen versehen zur Erzielung eines effektiveren Anschlusses des GaAs-Bauteils an eine optische Faser (siehe schwedische Patentanmeldung 8203597-3). Diese Kapselungstechnik hat den Nachteil, daß sie der erreichbaren Miniaturisierung enge Grenzen zieht und einen dominierenden Teil der Gesamtherstellungskosten für die Bauteile verursacht.

Der Erfindung liegt die Aufgabe zugrunde, eine hermetisch dichte Verbindung der eingangs genannten Art zu entwickeln, bei der die vorgenannten Nachteile im wesentlichen beseitigt sind.

Zur Lösung dieser Aufgabe wird eine hermetisch dichte Verbindung nach dem Oberbegriff des Anspruches 1 vorgeschlagen, die die im kennzeichnenden Teil des Anspruches 1 genannten Merkmale aufweist.

Vorteilhafte Ausgestaltungen der Verbindung sind in den Ansprüchen 2 bis 8 genannt.

Die möglichen Farbveränderungen auf der kontaktierenden Fläche des GaAs-Bauteils treten durch Oxidierung des GaAs auf und verursachen Haftprobleme. Bei der Verbindung gemäß der Erfindung ist dies vermieden, indem die Versiegelung in reduzierende Atmosphäre, beispielsweise in einem Gemisch aus Wasserstoff und Stickstoff, sowie unter Verarmung des in dem Glas normalerweise enthaltenen Sauerstoffüberschusses erfolgt. Das GaAs-Bauteil wird durch direkte Versiegelung am Glas eingekapselt, was beispielsweise nach dem in der US-PS 3 577 629 beschriebenen Verfahren geschehen kann. Die besonderen Schwierigkeiten, die bei der Verarbeitung von GaAs-Material auftreten, werden in jener Druckschrift nicht behandelt.

Die Versiegelung gemäß der Erfindung schafft Vorteile hinsichtlich der erreichbaren Miniaturisierung und führt zu einer Senkung der Fertigungskosten für optische Bauteile aus Galliumarsenid.

- 3 -

Anhand der Figuren soll die Erfindung näher erläutert werden.
Es zeigen

Fig. 1 veranschaulicht, wie ein GaAs-Bauteil an einer optischen Faser versiegelt werden kann,

Fig. 2 die Kapselung eines GaAs-Bauteils mit elektrischen Zuleitungen,

Fig. 3 ein Ausführungsbeispiel, bei dem ein GaAs-Bauteil an einem Glaskörper versiegelt ist,

Fig. 4 den Sensor für eine optische Druckmessung, der eine optische Faser enthält,

Fig. 5 eine Vorrichtung zur Herstellung einer hermetisch dichten Verbindung gemäß der Erfindung.

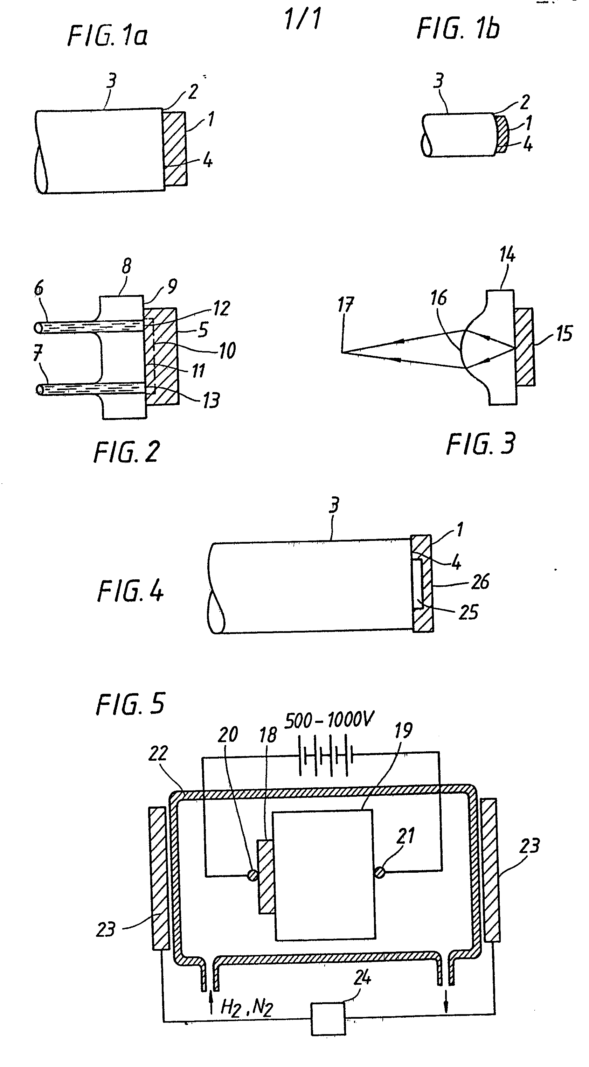

Figur 1 zeigt, wie ein GaAs-Bauteil 1 mit der Endfläche 2 einer optischen Faser 3 hermetisch dicht verbunden (versiegelt) werden kann. Ein Kennzeichen der Versiegelung besteht darin, daß die einander kontaktierenden Flächen der Faser und des GaAs-Bauteils innerhalb des optisch erfaßbaren Bereiches planpoliert sind, d.h. daß Unebenheiten, die größer als 0,1 $\mu$m sind, fehlen, wobei jedoch die makroskopische Oberflächenform der Flächen etwas von völliger Ebenheit abweichen kann (Unebenheiten, die kleiner als 100 $\mu$m sind, sind auch entfernt). Dies wird in Figur 1b gezeigt, wo die Endfläche 2 etwas konvex ist, wodurch die GaAs-Komponente 1 einer gewissen Biegebeanspruchung ausgesetzt ist. Die genannten beiden Kontaktflächen bilden eine Kontaktschicht 4, innerhalb derer sich die beiden Flächen mikroskopisch miteinander verzahnen. Ein anderes Kennzeichen ist das Fehlen von optisch erfaßbaren Farbveränderungen in der Kontaktschicht 4. Solche Farbveränderungen treten bei der Oxidation an der GaAs-Fläche auf. Aufgrund der geringen Haftfähigkeit des Oxyds an den Mutterkristallen führt das Vorhandensein von Oxyd zu einem minderwertigen Produkt. Die Konzentration an Sauerstoff im Glaskörper soll erheblich kleiner sein als die stöchiometrische Konzentration für Oxyde, die aus Gallium und Arsen in einem Volumen entstehen, das durch die Größe der gemeinsamen Kontaktfläche (4) und einen Abstand von dieser definiert ist, der 10 $\mu$m nicht unterschreitet. Andere Kennzeichen der Erfindung sind, daß in der Kontaktschicht 4 keine organischen oder anorganischen Bindemittel vorhanden sind. Doch kann das GaAs-Bauteil an sich Dotierungsstoffe oder Legierungszusätze, z.B. die oben genannten Aluminiumzusätze, enthalten.

Ein Ausführungsbeispiel für das GaAs-Bauteil ist ein faseroptischer Temperatursensor der in der DE-OS 30 36 682 beschriebenen Art, mit mindestens einem fotolumineszierenden Bereich. Ein anderes Ausführungsbeispiel ist eine sog. Fotolumineszenzdiode nach Art der EP-A- 81 10 4609.3, die auch aktive elektrische Schaltungselemente enthalten kann.

Figur 2 zeigt die Kapselung eines GaAs-Bauteils 5 mit elektrischen Zuleitungen 6, 7, die in einen Glaskörper 8 mit planpolierter Oberfläche 9 eingeschmolzen sind. Der aktive Bereich 10 des Bauteils ist an den übrigen Seiten von dem Muterkristall geschützt. Die Kontaktschicht 11 hat dieselben Merkmale, wie die oben beschriebene Kontaktschicht 4 in Figur 1. Die elektrischen Anschlußflächen 12, 13 können mit dünnen Metallbelägen versehen sein, die beispielsweise eine Legierung mit dem GaAs-Kristall und den Anschlüssen 6 und 7 bilden.

Figur 3 zeigt ein Ausführungsbeispiel, bei dem ein Glaskörper 14, der an ein GaAs-Bauteil 15 hermetisch dicht angeschlossen ist, durch die konvexe Begrenzungsfläche 16 ein optisches Linsenelement bildet, durch welches nach bekannten Gesetzen der geometrischen Optik das vom Bauteil 15 kommende Licht in einem Punkt 17 fokussiert wird.

Figur 4 zeigt einen optischen Druckgeber, der eine optische Faser 3 und einen Galliumarsenidkörper 1 enthält, der als elastische Membran 26 ausgebildet ist und einen evakuierenden oder gasgefüllten Raum 25 umgrenzt. Die Membran 26 ist eine bevorzugte Ausführungsform zum Abgeben von Fotolumineszenzlicht innerhalb mindestens einem Wellenlängenintervall.

Figur 5 zeigt ein Verfahren zur Bildung der hermetischen dichten Verbindung gemäß der Erfindung. Das GaAs-Bauteil 18 und der Glaskörper 19 sind über elektrische Anschlüsse 20, 21 an eine Hochspannungsquelle angeschlossen und in einem Behälter 22 untergebracht, der mit einem reduzierenden Gas, z.B. einer Mischung aus Stickstoff und Wasserstoff, belüftet wird. Der Behälter 22 ist mit einer Heizvorrichtung 23 versehen, mit deren Hilfe der Glaskörper 19 und das Bauteil 18 auf 400°C erhitzt werden können. Ein Temperaturregler 24 steuert die zugeführte Leistung.

Das Verfahren nach Figur 4 weicht von der in der US-PS 3 577 629 beschriebenen durch die Verwendung eines reduzierenden Gases ab. Es ist außerdem notwendig, im Glaskörper 19 im voraus den Überschuß an Sauerstoff abzubauen, was dadurch geschehen kann, daß der Glaskörper vor der Versiegelung in reduzierendem Gas aufbewahrt wird. (Siehe im übrigen das oben Gesagte betreffend die Konzentration von Sauerstoff).

Ferner darf der thermische Ausdehnungskoeffizient des Glaskörpers 19 nicht stark von dem des GaAs abweichen; letzterer beträgt $6 \times 10^{-6}$/°C. Eine diese Forderungen erfüllende Glasqualität ist im Handel erhältlich und wird von der Firma Corning unter der Bezeichnung 0211 angeboten.

Die Erfindung kann im Rahmen des allgemeinen offenbarten Erfindungsgedankens in vielfacher Weise variiert werden.

6 Frankfurt/Main 1 , 27.5.1983
Rathenauplatz 2-8          B/d 21 282 PE
Telefon: (06 11) *28 23 55
Telex: 4 189 066 itax d

**0097611**

## PATENTANSPRÜCHE:

1. Hermetisch dichte Verbindung (Versiegelung) zwischen einem Galliumarsenidbauteil (1, 5, 15) und einem Glaskörper (3 ,8, 14), wobei die Kontaktflächen keine Unebenheiten im Bereich von 0,1 $\mu$m bis 100 $\mu$m aufweisen, dadurch gekennzeichnet, daß die von den Kontaktflächen gebildete Kontaktschicht (4, 11) von organischen und/oder anorganischen Bindemitteln gereinigt ist und keine optisch erfaßbare Farbveränderungen aufweist und daß der Glaskörper so beschaffen ist, daß seine Sauerstoffkonzentration wesentlich niedriger ist als die stöchiometrische Konzentration für Oxyde, die aus Gallium und Arsen in einem Volumen gebildet werden können, das durch die beiden Teilen gemeinsame Kontaktfläche (4, 11) und einen Abstand von dieser Kontaktfläche von etwa 10 $\mu$m bestimmt wird.

2. Verbindung nach Anspruch 1, dadurch gekennzeichnet, daß der Glaskörper eine optische Faser (3) ist.

3. Verbindung nach Anspruch 1 oder 2, dadurch gekennzeichnet, daß der Glaskörper (8) oder das GaAs-Bauteil mit metallischen Zuleitungen (6, 7) versehen sind.

4. Verbindung nach Anspruch 1 oder 3, dadurch gekennzeichnet, daß der Glaskörper (14) als optisches Linsenelement ausgebildet ist.

5. Verbindung nach Anspruch 2, dadurch gekennzeichnet, daß das Galliumarsenidbauteil (1, 5, 15) dazu verwendet wird, Licht in die optische Faser (3) zu emittieren.

6. Verbindung nach einem der vorhergehenden Ansprüche, dadurch gekennzeichnet, daß das Galliumarsenidbauteil (1,5,15) aktive elektrische Schaltungselemente enthält.

/7

- 7 -

7. Verbindung nach einem der vorhergehenden Ansprüche, dadurch gekennzeichnet, daß ein evakuierter oder gasgefüllter Raum (25) durch Versiegelung gegenüber der Umgebung abgedichtet ist.

8. Verbindung nach Anspruch 7, dadurch gekennzeichnet, daß das Galliumarsenidbauteil (1) in mindestens einer Hinsicht als elastische Membran (25) oder als ein fest eingespannter elastischer Balken ausgebildet ist.

27.5.1983
21 282 PE

0097611

1/1

FIG. 1a

FIG. 1b

FIG. 2

FIG. 3

FIG. 4

FIG. 5

$500-1000V$

$H_2 , N_2$